# EUROPEAN PATENT APPLICATION

(11) **EP 4 600 410 A1**
(43) Date of publication of application: **13.08.2025**
(21) Application number: 23874562.4
(22) Date of filing: 28.08.2023
(51) Int. Cl.: C30B 29/16, C30B 33/02, H01L 21/20, H01L 21/365

(54) **EPITAXIAL WAFER, AND METHOD FOR PRODUCING SAME**

(30) Priority: 03.10.2022 JP 2022159685
(71) Applicant: Novel Crystal Technology, Inc., Sayama-shi, Saitama 350-1328 (JP)
(72) Inventor: LIN, Chia-Hung, Sayama-Shi, Saitama 350-1328 (JP); SASAKI, Kohei, Sayama-Shi, Saitama 350-1328 (JP)
(74) Representative: Betten & Resch
(86) International application number: PCT/JP2023/030992
(87) International publication number: WO 2024/075430

(57) **Abstract**

Provided is a method for producing an epitaxial wafer, the method comprising: a step for exposing a substrate 10 comprising a β-Ga₂O₃-based single crystal and containing a donor impurity to a GaCl gas and an O₂ gas to allow an epitaxial film 12 comprising the β-Ga₂O₃-based single crystal to grow on a main surface 11 of the substrate 10 by an HVPE method, thereby forming an epitaxial wafer 1; and a step for subjecting the epitaxial wafer 1 to an annealing treatment at a temperature of 1200°C or higher under a nitrogen atmosphere.

## Description

### Technical Field

The present invention relates to an epitaxial wafer and a method for producing the same.

### Background Art

A technique for growing a β-Ga₂O₃-based single crystal film on a main surface of a β-Ga₂O₃-based single crystal substrate by the HVPE (Halide Vapor Phase Epitaxy) method is known (see, e.g., PTL 1). In the technique of PTL1, the β-Ga₂O₃-based single crystal substrate is exposed to a gallium chloride-based gas as a Ga source gas and an oxygen-containing gas as an oxygen source gas to epitaxially grow the β-Ga₂O₃-based single crystal film on the main surface of the β-Ga₂O₃-based single crystal substrate.

PTL 1 discloses that if hydrogen is contained in an atmosphere during growth of the β-Ga₂O₃-based single crystal film, surface flatness and a driving force for crystal growth of the β-Ga₂O₃-based single crystal film decrease, hence, it is preferable that an O₂ gas not containing hydrogen be used as the oxygen-containing gas.

### Citation List

### Patent Literature

PTL 1: JP 2015/91740 A

### Summary of Invention

### Technical Problem

However, in the technique of PTL 1, when an O₂ gas is used as the oxygen source gas, donor impurities in the β-Ga₂O₃-based single crystal substrate are inactivated due to exposure of the β-Ga₂O₃-based single crystal substrate to the O₂ gas during epitaxial growth of the β-Ga₂O₃-base single crystal film. Therefore, after depositing the B-Ga₂O₃-based single crystal film, annealing in a nitrogen atmosphere is required to reactivate the donor impurities in the β-Ga₂O₃-based single crystal substrate.

It is an object of the invention to provide a method for producing an epitaxial wafer having an epitaxial film formed of a β-Ga₂O₃-based single crystal on a substrate formed of a β-Ga₂O₃-based single crystal, the method being capable of more effectively reactivating a donor impurity in the substrate that has been inactivated due to use of an O₂ gas as an oxygen source gas for the epitaxial film in the HVPE method, and an epitaxial wafer produced by the method. Solution to Problem

To achieve the above-mentioned object, an aspect of the present invention provides a method for producing an epitaxial wafer, and an epitaxial wafer defined below.
(1) A method for producing an epitaxial wafer, comprising:
   using a HVPE method and forming an epitaxial wafer by exposing a substrate comprising a B-Ga₂O₃-based single crystal and including a donor impurity to a GaCl gas and an O₂ gas and thereby growing an epitaxial film comprising a β-Ga₂O₃-based single crystal on a main surface of the substrate; and
   annealing the epitaxial wafer at a temperature of not less than 1200°C in a nitrogen atmosphere.
(2) The method for producing an epitaxial wafer defined in (1), wherein the temperature of the annealing is not more than 1400°C.
(3) An epitaxial wafer, comprising:
   a substrate comprising a β-Ga₂O₃-based single crystal and including a donor impurity; and
   an epitaxial film comprising a β-Ga₂O₃-based single crystal on the substrate,
   wherein a donor concentration of the substrate is not less than 80% of a concentration of the donor impurity,
   wherein a Cl concentration of the epitaxial film is not less than 1 × 10¹⁴ cm⁻³, and
   wherein a H concentration of the substrate and the epitaxial film is not more than 3 × 10¹⁷ cm⁻³.
(4) The epitaxial wafer defined in (3), wherein variation in the donor concentration in a plane of the substrate from a central value between the maximum and minimum values of the donor concentration in the plane of the substrate is not more than 10%.

### Advantageous Effects of Invention

According to the invention, it is possible to provide a method for producing an epitaxial wafer having an epitaxial film formed of a β-Ga₂O₃-based single crystal on a substrate formed of a β-Ga₂O₃-based single crystal, the method being capable of more effectively reactivating a donor impurity in the substrate that has been inactivated due to use of an O₂ gas as an oxygen source gas for the epitaxial film in the HVPE method, and an epitaxial wafer produced by the method.

### Brief Description of Drawings

FIG. 1 is a vertical cross-sectional view showing an epitaxial wafer in an embodiment of the present invention.
FIG. 2 is a vertical cross-sectional view showing a vapor-phase growth apparatus in the embodiment of the invention.
FIG. 3 is a graph showing temperature change in an annealing furnace when annealing is performed on an epitaxial wafer.
FIG. 4 is a graph showing the activation rate of donor impurity in a substrate before and after depositing an epitaxial film and after annealing at 1150 to 1400°C.
FIG. 5 is a graph showing concentrations of impurities in the epitaxial wafer, as measured by secondary ion mass spectrometry (SIMS).

### Description of Embodiments

### (Configuration of an epitaxial wafer)

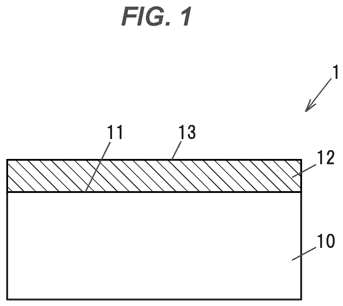

FIG. 1 is a vertical cross-sectional view showing an epitaxial wafer 1 in the embodiment of the invention. The epitaxial wafer 1 has a substrate 10 that is formed of a β-Ga₂O₃-based single crystal and includes a donor impurity, and an epitaxial film 12 that is formed of a β-Ga₂O₃-based single crystal and is formed on a main surface 11 of the substrate 10 by epitaxial crystal growth.

The β-Ga₂O₃-based single crystal here means a β-Ga₂O₃ single crystal, or means a β-Ga₂O₃ single crystal doped with an element such as Al or In, and is, e.g., a β-(GaₓAl_{y}In_{(1-x-y)})₂O₃ (0<x≤1, 0≤y≤1, 0<x+y≤1) single crystal which is a β-Ga₂O₃ single crystal doped withAl and In. The band gap is widened by adding Al and the band gap is narrowed by adding In.

To form the substrate 10, for example, a bulk crystal of a Ga₂O₃ single crystal grown by a melt-growth technique such as the FZ (Floating Zone) method or the EFG (Edge Defined Film-Fed Growth) method is sliced and the surfaces are then polished. The substrate 10 includes a donor impurity such as Sn, Si, Ge. A donor concentration of the substrate 10 is not less than 80% of a concentration of the donor impurity included in the substrate 10.

The epitaxial film 12 is deposited on the substrate 10 by the HVPE (Halide Vapor Phase Epitaxy) method. The epitaxial film 12 may include a donor impurity such as Sn, Si, Ge, or an acceptor impurity such as Mg. The epitaxial film 12 is formed by the HVPE method using a Cl-containing gas as a source gas and thus includes Cl at a concentration of not less than 1 × 10¹⁴ cm⁻³.

In addition, to form the epitaxial film 12, an O₂ gas not containing H is used as an oxygen source gas. Therefore, a concentration of H included in the substrate 10 and the epitaxial film 12 is low and is not more than 3 × 10¹⁷ cm⁻³.

### (Structure of a vapor-phase growth apparatus)

An example structure of a vapor-phase growth apparatus used to grow the epitaxial film 12 in the embodiment of the invention will be described below.

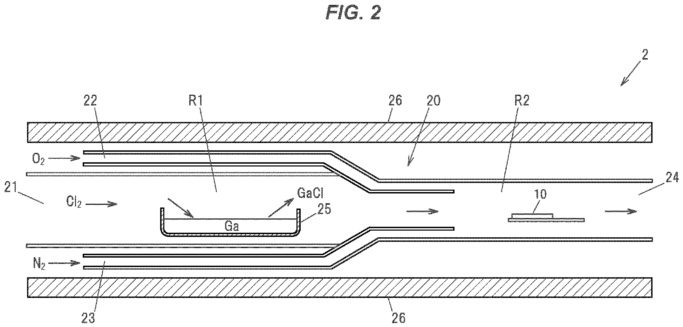

FIG. 2 is a vertical cross-sectional view showing a vapor-phase growth apparatus 2 in the embodiment of the invention. The vapor-phase growth apparatus 2 is a vapor-phase growth apparatus for the HVPE method, and has a reactor 20 having a first gas introducing port 21, a second gas introducing port 22, a third gas introducing port 23 and an exhaust port 24, and a heating unit 26 placed around the reactor 20 to heat the inside of the reactor 20.

The reactor 20 has a source reaction region R1 in which a reaction container 25 containing a Ga source is placed and a gallium source gas is produced, and a crystal growth region R2 in which the substrate 10 is placed and the epitaxial film 12 is grown thereon. The reactor 20 is formed of, e.g., quartz glass.

The reaction container 25 is formed of, e.g., quartz glass and the Ga source contained in the reaction container 25 is metal gallium.

The heating unit 26 is capable of heating the source reaction region R1 and the crystal growth region R2 of the reactor 20. The heating unit 26 is, e.g., a resistive heater or radiation heater.

The first gas introducing port 21 is a port to introduce a Cl-containing gas, which is Cl₂ gas or HCl gas, into the source reaction region R1 of the reactor 20 using a carrier gas (N₂ gas, Ar gas or He gas) which is an inert gas. The second gas introducing port 22 is a port to introduce an O₂ gas, which is an oxygen source gas, into the crystal growth region R2 of the reactor 20 using a carrier gas (N₂ gas, Ar gas or He gas) which is an inert gas. The third gas introducing port 23 is a port to introduce a chloride-based gas (e.g., silicon tetrachloride, etc.), which is used to dope the epitaxial film 12 with a dopant such as Si, into the crystal growth region R2 of the reactor 20 using a carrier gas (N₂ gas, Ar gas or He gas) which is an inert gas.

### (Growth of the epitaxial film)

An example process of growing the epitaxial film 12 in the present embodiment will be described below.

First, while maintaining the ambient temperature in the source reaction region R1 of the reactor 20 at a predetermined temperature, e.g., at 500 to 900°C by means of the heating unit 26, a Cl-containing gas is introduced through the first gas introducing port 21 using a carrier gas and the reaction between the Cl-containing gas and the metal gallium in the reaction container 25 is caused at the above-mentioned ambient temperature in the source reaction region R1, thereby producing a GaCl gas.

If hydrogen is contained in an atmosphere during growth of the epitaxial film 12, surface flatness and a driving force for crystal growth of the epitaxial film 12 decrease. Therefore, it is preferable that a Cl₂ gas not containing hydrogen be used as the Cl-containing gas.

GaCl₂ gas, GaCl₃ gas, and (GaCl₃)₂ gas, which are gallium chloride-based gases other than the GaCl gas, are also produced from the reaction between the metal gallium and the Cl-containing gases. However, the partial pressure of the GaCl gas is by far the highest among these gallium chloride-based gases and the gases other than the GaCl gas hardly contribute to the growth of Ga₂O₃-based single crystal.

Next, while maintaining the ambient temperature in the crystal growth region R2 of the reactor 20 at a predetermined temperature, e.g., at 800 to 1100°C by means of the heating unit 26, the GaCl gas produced in the source reaction region R1 and the O₂ gas introduced through the second gas introducing port 22 are mixed in the crystal growth region R2 and the substrate 10 is exposed to the resulting mixed gas, thereby epitaxially growing the epitaxial film 12 on the main surface 11 of the substrate 10. At this time, pressure in the crystal growth region R2 in a furnace housing the reactor 20 is maintained at, e.g., 1 atm.

Here, in case of forming the epitaxial film 12 including an additive element such as Si or Al, a source gas of the additive element (e.g., a chloride-based gas such as silicon tetrachloride (SiCl₄)) is also introduced, together with the GaCl gas and the O₂ gas, into the crystal growth region R2 through the third gas introducing port 23.

By using the O₂ gas as the oxygen source gas, it is possible to suppress a decrease in the surface flatness and driving force for crystal growth of the epitaxial film 12 which are caused by hydrogen contained in the atmosphere during growth of the epitaxial film 12, as compared to when using a gas containing H, such as H₂O gas.

Next, the epitaxial wafer 1 is transferred from the vapor phase growth apparatus 2 to an annealing furnace and is annealed at a temperature of not less than 1200°C in a nitrogen atmosphere to reactivate the donor impurity in the substrate 10 that has been inactivated due to exposure of the substrate 10 to the O₂ gas during deposition of the epitaxial film 12.

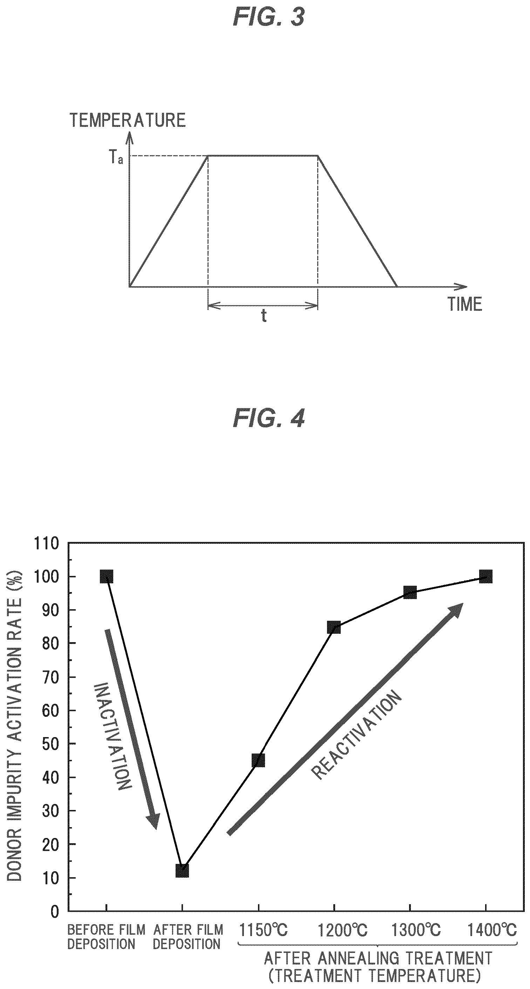

FIG. 3 is a graph showing temperature change in an annealing furnace when annealing is performed on the epitaxial wafer 1. As shown in FIG. 3, the temperature is raised from room temperature to an annealing temperature Tₐ, is held at the temperature Tₐ for a time t, and is then lowered to room temperature. The annealing temperature Tₐ here is, e.g., in the range of not less than 1200°C and not more than 1400°C. The time t for holding the temperature Tₐ is, e.g., in the range not less than 1 hour and not more than 10 hours.

FIG. 4 is a graph showing the activation rate of donor impurity in the substrate 10 before and after depositing the epitaxial film 12 (indicated as before film deposition and after film deposition) and after annealing at 1150 to 1400°C.

The activation rate of donor impurity is a percentage of donor impurities actually acting as donors among all donor impurities and is equal to a ratio of the donor concentration to the concentration of the donor impurity. Before deposition of the epitaxial film 12, the donor concentration is substantially equal to the concentration of the donor impurity and the activation rate of donor impurity is substantially 100%.

The activation rate of donor impurity in the substrate 10 shown in FIG. 4 was determined as a ratio of the donor concentration to the donor concentration before deposition of the epitaxial film 12. To obtain the donor concentration of the substrate 10, the substrate 10 side of the epitaxial wafer 1 was polished by chemical mechanical polishing (CMP) and electrochemical capacitance-voltage (ECV) measurement was then conducted on the substrate 10.

In this regard, the substrate 10 pertain to FIG. 4 is a substrate formed of a β-Ga₂O₃ single crystal including Sn and Si as donor impurities (Si is an impurity unintentionally included in the raw material of the substrate 10), but regardless of the type of β-Ga₂O₃-based single crystal constituting the substrate 10 or the type of the donor impurity, similar results to those in FIG. 4 are obtained.

According to FIG. 4, the activation rate of donor impurity drops to 12% due to exposure of the substrate 10 to the O₂ gas during deposition of the epitaxial film 12, and the activation rate is restored by subsequent annealing.

In addition, according to FIG. 4, when the annealing temperature is not less than 1200°C, the activation rate of the donor impurities in the substrate 10 is not less than 80%, i.e., the donor concentration is not less than 80% of the donor impurity concentration, and the reactivation rate increases as increasing the annealing temperature. The activation rates at the annealing temperatures of 1150°C, 1200°C, 1300°C, and 1400°C in FIG. 4 are respectively 45%, 84.8%, 95.2%, and 100%.

When the annealing temperature is more than 1400°C, the amount of thermal decomposition of the β-Ga₂O₃-based single crystal increases, hence, the annealing temperature is preferably not more than 1400°C. When the annealing temperature is not more than 1400°C, the amount of thermal decomposition (the amount of reduction in film thickness due to thermal decomposition) of the epitaxial film 12 formed of a β-Ga₂O₃-based single crystal can be suppressed to not more than 1 µm.

Table 1 below shows the amount of change in film thickness of the epitaxial film 12 before and after annealing when the annealing temperature is 1400°C. Table 1 shows the amount of change in film thickness at five different positions on the epitaxial film 12, as measured using a Fourier transform infrared spectrophotometer (FTIR).

**(Table 1)**

| | Position 1 | Position 2 | Position 3 | Position 4 | Position 5 |
|---|---|---|---|---|---|
| Before annealing | 17.6 | 17.5 | 18.0 | 19.1 | 17.8 |
| After annealing | 17.4 | 16.9 | 17.5 | 18.6 | 17.4 |
| Amount of change | 0.2 | 0.6 | 0.5 | 0.5 | 0.4 |

According to Table 1, the amount of change in film thickness is not more than 1.0 µm at any position, which shows that the thermal decomposition of the epitaxial film 12 is suppressed. The epitaxial wafer 1 is colorless and transparent before annealing, but after annealing at a temperature of not less than about 1200°C, the color changes to light blue.

To perform annealing at a temperature of not less than 1200°C, for example, an electric annealing furnace made of alumina is used. With general-purpose annealing furnaces made of quartz, it is difficult to perform annealing at not less than 1200°C due to the heat resistance temperature of quartz. In general, the maximum annealing temperature that can be achieved in general-purpose annealing furnaces made of quartz is about 1150°C, and the activation rate in this case is about 45% as shown in FIG. 4.

In addition, to suppress contamination of the epitaxial wafer 1, the annealing furnace used for annealing is preferably made of a material not containing Si or C, such as alumina.

When annealing was performed at a temperature of not less than 1200°C and not more than 1400°C, variation in the donor concentration in a plane of the substrate 10 from a central value between the maximum and minimum values of the donor concentration in the plane of the substrate 10 was not more than 10%.

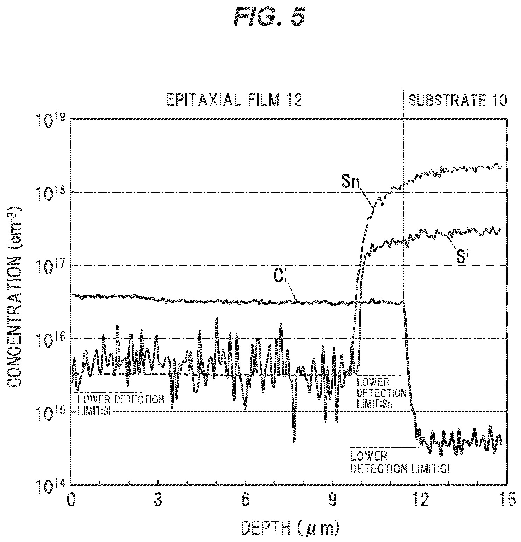

FIG. 5 is a graph showing concentrations of impurities in the epitaxial wafer 1, as measured by secondary ion mass spectrometry (SIMS). In the epitaxial wafer 1 pertain to FIG. 5, the substrate 10 is a substrate formed of a β-Ga₂O₃ single crystal including Sn and Si as donor impurities (Si is an impurity unintentionally included in the raw material of the substrate 10), and the epitaxial film 12 is a film formed of a β-Ga₂O₃ single crystal including Si as a donor impurity at a concentration of 3.0 × 10¹⁵ cm⁻³.

In FIG. 5, the horizontal axis represents the depth (µm) from a surface 13 of the epitaxial film 12 of the epitaxial wafer 1, and the vertical axis represents the concentration (cm⁻³) of each impurity. The depth of the interface between the substrate 10 and the epitaxial film 12 in the epitaxial wafer 1 here is about 11.3 µm.

FIG. 5 shows the concentrations of Si, Sn, and Cl in the epitaxial wafer 1. According to FIG. 5, the concentration of Sn in the epitaxial film 12 is close to the lower detection limit of the SIMS analyzer (indicated as Lower detection limit: Sn), confirming that unintentional incorporation of Sn into the epitaxial film 12 did not occur. The concentrations of Si and Sn in the region of the epitaxial film 12 near the interface with the substrate 10 are high, but this is due to diffusion of Si and Sn included in the substrate 10 to the epitaxial film 12 and does not pose a problem.

In addition, according to FIG. 5, the epitaxial film 12 includes Cl at a concentration of about 2.9 × 10¹⁶ to 4.0 × 10¹⁶ cm⁻³. This is caused because the epitaxial film 12 is formed by the HVPE method using a Cl-containing gas. In general, when forming a β-Ga₂O₃-based single crystal film by a method not using a Cl-containing gas or by a method using a Cl-containing gas other than the HVPE method (e.g., the MOVPE method using a SiCl₄ gas), the β-Ga₂O₃-based single crystal film does not contain Cl, or at least does not contain not less than 1 × 10¹⁴ cm⁻³ of Cl.

### (Effects of the embodiment)

According to the above-described embodiment of the invention, by annealing the epitaxial wafer 1 at a temperature of not less than 1200°C in a nitrogen atmosphere after deposition of the epitaxial film 12, it is possible to effectively reactivate the donor impurity in the substrate 10 that has been inactivated due to use of the O₂ gas as an oxygen source gas for the epitaxial film 12 in the HVPE method.

Although the embodiment of the invention has been described, the invention is not intended to be limited to the embodiment, and the various kinds of modifications can be implemented without departing from the gist of the invention. In addition, the constituent elements in the embodiment can be arbitrarily combined without departing from the gist of the invention. In addition, the invention according to claims is not to be limited to the embodiment described above. Further, it should be noted that not all combinations of the features described in the embodiment are necessary to solve the problem of the invention.

### Industrial Applicability

Provided are a method for producing a β-Ga₂O₃-based epitaxial wafer which is an epitaxial wafer producing method capable of more effectively reactivating a donor impurity in a substrate that has been inactivated due to use of an O₂ gas as an oxygen source gas for an epitaxial film in the HVPE method, and an epitaxial wafer produced by the method.

### Reference Signs List

1 EPITAXIAL WAFER
10 SUBSTRATE
11 MAIN SURFACE
12 EPITAXIAL FILM
2 VAPOR-PHASE GROWTH APPARATUS
20 REACTOR
21 FIRST GAS INTRODUCING PORT
22 SECOND GAS INTRODUCING PORT
23 THIRD GAS INTRODUCING PORT
24 EXHAUST PORT
25 REACTION CONTAINER
26 HEATING UNIT

## Claims

1. A method for producing an epitaxial wafer, comprising:
using a HVPE method and forming an epitaxial wafer by exposing a substrate comprising a β-Ga₂O₃-based single crystal and including a donor impurity to a GaCl gas and an O₂ gas and thereby growing an epitaxial film comprising a β-Ga₂O₃-based single crystal on a main surface of the substrate; and
annealing the epitaxial wafer at a temperature of not less than 1200°C in a nitrogen atmosphere.

2. The method for producing an epitaxial wafer according to claim 1, wherein the temperature of the annealing is not more than 1400°C.

3. An epitaxial wafer, comprising:
a substrate comprising a β-Ga₂O₃-based single crystal and including a donor impurity; and
an epitaxial film comprising a β-Ga₂O₃-based single crystal on the substrate,
wherein a donor concentration of the substrate is not less than 80% of a concentration of the donor impurity,
wherein a Cl concentration of the epitaxial film is not less than 1 × 10¹⁴ cm⁻³, and
wherein a H concentration of the substrate and the epitaxial film is not more than 3 × 10¹⁷ cm⁻³.

4. The epitaxial wafer according to claim 3, wherein variation in the donor concentration in a plane of the substrate from a central value between the maximum and minimum values of the donor concentration in the plane of the substrate is not more than 10%.
